**Europäisches Patentamt**

**European Patent Office**

**Office européen des brevets**

(19)

(11) **EP 1 528 672 A2**

(12) ## EUROPEAN PATENT APPLICATION

(43) Date of publication:
04.05.2005 Bulletin 2005/18

(51) Int Cl.$^7$: **H03H 9/02**

(21) Application number: **04025681.0**

(22) Date of filing: **28.10.2004**

| | |
|---|---|
| (84) Designated Contracting States:<br>**AT BE BG CH CY CZ DE DK EE ES FI FR GB GR HU IE IT LI LU MC NL PL PT RO SE SI SK TR**<br>Designated Extension States:<br>**AL HR LT LV MK** | (72) Inventors:<br>• **Funasaka, Tsukasa**<br>  **Suwa-shi, Nagano-ken 392-8502 (JP)**<br>• **Oshio, Masahiro**<br>  **Suwa-shi, Nagano-ken 392-8502 (JP)** |
| (30) Priority: **30.10.2003 JP 2003371081** | (74) Representative: **HOFFMANN - EITLE**<br>**Patent- und Rechtsanwälte**<br>**Arabellastrasse 4**<br>**81925 München (DE)** |
| (71) Applicant: **Seiko Epson Corporation**<br>**Shinjuku-ku, Tokyo 163-0811 (JP)** | |

(54) **Surface acoustic wave element and electronic equipment**

(57)     In order to provide a surface acoustic wave element which is excellent in various kinds of characteristics (especially temperature characteristic), and electronic equipment having such surface acoustic wave element, a surface acoustic wave element (1) comprises, as a substrate (2), a quartz-rotator Y plate whose Euler angle is expressed as $(0, \theta, \psi)$, and IDT 3 and reflectors (4) and (5) provided on this substrate 2. The IDT 3 is formed of Al as its main ingredient, and arranged so that an angle $\psi$, which the propagation direction of a surface acoustic wave and the X-axis of the quartz-rotator Y plate make, may become $90 \pm 10°$, and a normalized film-thickness $H/\lambda$ of IDT 3, and the cut angle $\theta$ are set as to satisfy the following Relation A.

(Relation A)

$$\theta_{min} <= \theta <= \theta_{max} \text{ (where, } \theta = 129 \text{ through } 144°)$$

$$\theta_{min} = 857.06(H/\lambda)^2 + 23.656(H/\lambda) + 123.68$$

$$\theta_{max} = 2502.4(H/\lambda)^2 + 73.1(H/\lambda) + 121.7$$

FIG. 1

EP 1 528 672 A2

## Description

### [Field of the Invention]

The present invention relates to a surface acoustic wave element and electronic equipment.

### [Background of the invention]

A wave that propagates concentrating energy near the surface of a propagation medium is known as a surface acoustic wave (SAW). A surface acoustic wave element is an element using such surface acoustic wave, and is applied to a band pass filter for communication apparatus, such as a cellular phone, a resonator as a reference clock, a delay element for signal processing (especially Fourier transform functional element), various kind of sensors like a pressure sensor and a temperature sensor, and a light deflector or the like.

For example, a surface acoustic wave element used as a filter or a resonator comprises: a piezoelectric substrate as a propagation medium of the surface acoustic wave; a pair of interdigital transducers (Interdigital Transducer: IDT), which is provided on this piezoelectric substrate, used for an input to which a voltage to excite a surface acoustic wave in the piezoelectric substrate is applied, and used for an output to detect the surface acoustic wave that propagates in the piezoelectric substrate, and to convert to an electric signal and output; and a pair of reflectors arranged at both side portions of the IDT.

In such surface acoustic wave element, when an AC power (electric signal) is provided to the IDT used for the input, distortion arises in the piezoelectric substrate by an electric field due to this AC power. At this time, condensation and rarefaction arise in the piezoelectric substrate because of the comb-teeth shape of the electrode which produces this electric field, and thereby a surface acoustic wave occurs.

This surface acoustic wave propagates to both sides of the IDT, and is reflected by the reflector to produce resonance between the reflectors. Then, energy of this surface acoustic wave is converted to an electric energy and outputted by the IDT used for the output.

Incidentally, the characteristics required for the surface acoustic wave element includes that frequency variation to temperature change is small (temperature characteristic is excellent), that an electromechanical coupling coefficient $k^2$ is large, that the reflection coefficient of the surface acoustic wave is large in case that the reflector is used or the like.

Among these, especially the temperature characteristic is important in the surface acoustic wave element used as a resonator or a narrow-band filter.

The surface acoustic wave element excellent in the temperature characteristic includes the one forming the IDT and the reflector on a ST-cut 0° quartz substrate of X-axis propagation and using Rayleigh wave generated by the excitation of the IDT.

However, because the Rayleigh wave has a small reflective coefficient against the reflector, a number of reflectors are needed in order to obtain a sufficient amount of reflection, and as a result, the size thereof becomes large, which is disadvantageous for miniaturization of the surface acoustic wave element. Moreover, the Rayleigh wave has a small electromechanical coupling coefficient $k^2$, and thus has a problem that losses during the conversion of an electric signal and a surface acoustic wave are large.

Moreover, as a surface acoustic wave element using SH wave (Share Horizontal wave), the one forming the IDT and the reflector on a ST-cut 90° quartz substrate of X-axis propagation has been proposed (for example, refer to Patent Document 1, Patent Document 2, and Patent Document 3).

However, this surface acoustic wave element uses a heavy metal-film as the interdigital transducer, therefore, is excellent in the reflective coefficient and the electromechanical coupling coefficient $k^2$, however, there is a drawback that frequency variation to the variation of the film thickness of the electrode is large.

Moreover, STW (Surface Transversal Wave) is known as one type of the SH wave on a quartz substrate (for example, Patent Document 4), however, in this case, θ of around 128.4 as the cut angle is used, and thus there is a drawback that the second-order temperature coefficient is worse than that of the Rayleigh wave of ST cut.

### [Relevant Prior Art Documents]

[Patent Document 1]
Japanese Examined Patent Publication No. S61-45892

[Patent Document 2]

Japanese Unexamined Patent Publication No. H10-233645

[Patent Document 3]
Japanese Unexamined Patent Publication No. 2000-323956

[Patent Document 4]
US Pat. 4965479

**[Summary of the Invention]**

The present invention is intended to provide a surface acoustic wave element excellent in various kinds of characteristics (especially temperature characteristic), and electronic equipment comprising such surface acoustic wave element.

**[Solution and further aspects/advantages of the Invention]**

Such objectives are attained according to the following invention. A surface acoustic wave element according to the present invention comprises a quartz-rotator Y plate whose Euler angle is expressed with (0, θ, ψ), and a interdigital transducer that is provided on this quartz-rotator Y plate, and has a function to change an electric signal into a surface acoustic wave which propagates near the surface of the quartz-rotator Y plate, and/or a function to change the surface acoustic wave which propagates near the surface of the quartz-rotator Y plate into an electric signal, wherein the interdigital transducer is formed of Al as a major ingredient, and arranged so that an angle ψ, which the propagation direction of the surface acoustic wave and the X-axis of the quartz-rotator Y plate make, may become $90 \pm 10°$, and a normalized film-thickness H/λ of the interdigital transducer (H denotes an average thickness of the interdigital transducer, and λ denotes the wavelength of the surface acoustic wave) and the cut angle θ are set as to satisfy the following Relation A:

(Relation A)

$$\theta\text{min} \leq \theta \leq \theta\text{max (where, } \theta = 129 \text{ through } 144°)$$

$$\theta\text{min} = 857.06(H/\lambda)^2 + 23.656(H/\lambda) + 123.68$$

$$\theta\text{max} = 2502.4(H/\lambda)^2 + 73.1(H/\lambda) + 121.7$$

Accordingly, the surface acoustic wave element excellent in various kinds of characteristics (especially temperature characteristic) is obtained.

According to the surface acoustic wave element of the present invention, it is preferable that the normalized film-thickness H/λ is 0.03 through 0.14. Accordingly, the temperature characteristic is further improved, and the elec-tromechanical coupling coefficient $k^2$ also becomes large, and the energy loss during the electromechanical conversion can be suppressed to be small.

According to the surface acoustic wave element of the present invention, it is preferable that the surface acoustic wave is the one having a surface transversal wave as the major component.

Because the acoustic velocity of the surface transversal wave is fast, the surface acoustic wave element of higher frequency can be attained by using the one having the surface transversal wave as the major component, as the surface acoustic wave.

According to the surface acoustic wave element of the present invention, the angle ψ is $90 \pm 2°$. Accordingly, STW can be efficiently used as the surface acoustic wave.

A surface acoustic wave element according to the present invention comprises a pair of reflectors provided via the interdigital transducer, wherein each of the reflectors is formed of Al as the major ingredient, and arranged so that the angle ψ, which the propagation direction of the surface acoustic wave and the X-axis of the quartz-rotator Y plate make, may become $90 \pm 10°$, and it is preferable that the normalized film-thickness of each of the reflectors and the cut angle θ are set as to satisfy the Relation A. Accordingly, various kinds of characteristics (especially temperature characteristic) are further improved.

It is preferable that the surface acoustic wave element according to the present invention comprises an insulating protection film provided at least in an upper surface of the interdigital transducer. This can prevent foreign particles from adhering to the surface of the interdigital transducer, and can prevent short-circuiting via the foreign particles.

An electronic equipment according to the present invention comprises the surface acoustic wave element according to the present invention. Accordingly, electronic equipment having high reliability is obtained.

Further advantageous embodiments and improvements of the invention can be taken from the dependent claims. Hereinafter, the invention will be described with reference to its embodiments and the attached drawings.

**[Brief Description of the Drawings]**

In the drawings:

**FIG. 1** is a perspective view schematically showing a first embodiment of a surface acoustic wave element of the present invention;

**FIG. 2** is a cross sectional view of the surface acoustic wave element shown in FIG. 1;

**FIG. 3** is a graph showing a relation between an angle ψ and an electromechanical coupling coefficient $k^2$ of various kinds of surface acoustic waves;

**FIG. 4** is a graph showing a relation between a cut angle θ of a quartz-rotator Y plate, and the second-order temperature coefficient;

**FIG. 5** is a graph showing a relation between a normalized film-thickness H/λ of an IDT and a cut angle θ of a quartz-rotator Y plate;

**FIG. 6** is a perspective view showing a second embodiment of the surface acoustic wave element of the present invention;

**FIG. 7** is a cross sectional view of the surface acoustic wave element shown in FIG. 6;

**FIG. 8** is electronic equipment having the surface acoustic wave element of the present invention (notebook type personal computer);

**FIG. 9** is electronic equipment having the surface acoustic wave element of the present invention (cellular phone);

**FIG. 10** is electronic equipment having the surface acoustic wave element of the present invention (digital still camera);

**FIG. 11** is a graph showing the impedance characteristic of the surface acoustic wave element of an embodiment 1; and

**FIG. 12** is a graph showing the impedance characteristic of the surface acoustic wave element of a comparative example 1.

**[Description of the Preferred Embodiments]**

Hereinafter, suitable embodiments of the surface acoustic wave element and electronic equipment of the present invention will be described.

**<First embodiment>**

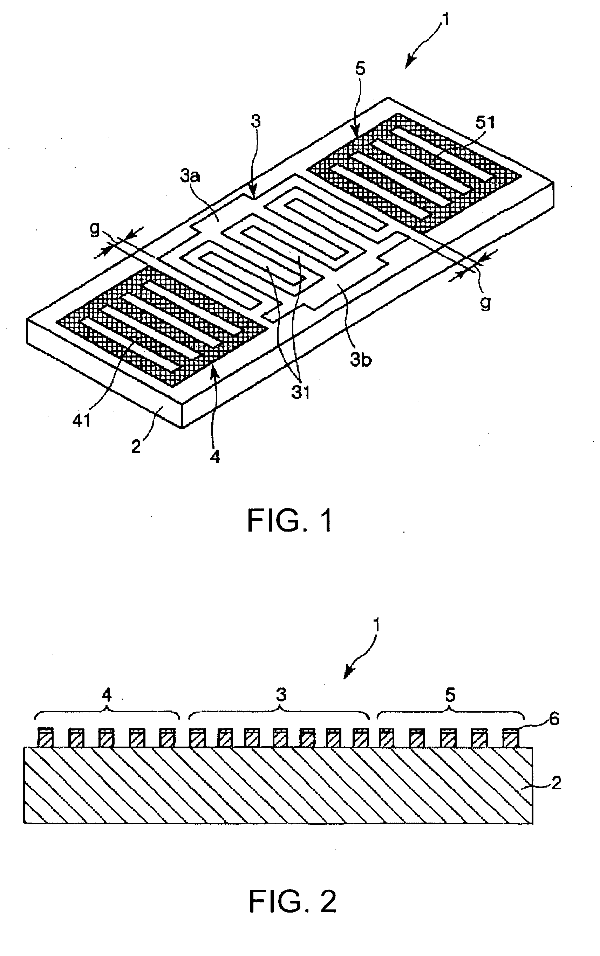

FIG. 1 is a perspective view schematically showing a first embodiment of the surface acoustic wave element of the present invention, and FIG. 2 is a cross sectional view of the surface acoustic wave element shown in FIG. 1. In addition, in the following description, the upper side in FIG. 2 is called a "top" and the lower side is called a "bottom".

The surface acoustic wave element 1 shown in FIG. 1 and FIG. 2 has a substrate 2, an IDT 3 provided on the substrate 2, a pair of reflectors 4 and 5 arranged at the both side portions of the IDT 3, an insulating protection film 6 provided in the top face of the IDT 3 and the reflectors 4 and 5.

In the present invention, a quartz-rotator Y plate is used as the substrate 2. Accordingly, in the surface acoustic wave element 1, a surface acoustic wave with a large electromechanical coupling coefficient $k^2$ is excited. The present invention prescribes the angle ψ and the cut angle θ of the Euler angle (0, θ, ψ) in this quartz-rotator Y plate, and a

4

relation of the cut angle θ and the normalized film-thickness H/λ (H denotes the average thickness of the interdigital transducer, and λ denotes the wavelength of the surface acoustic wave) of the IDT 3, and the composition material of the IDT 3. In addition, these will be described in detail, hereinafter.

The (average) thickness of the substrate 2 is not specifically limited, however, preferably it is approximately 0.05 through 1 mm, and more preferably approximately 0.1 through 0.8 mm. The surface acoustic wave element 1 is a type of element so-called one-port type, and has electrodes 3a and 3b which have a function to excite a surface acoustic wave in the substrate 2 by applying a voltage to the substrate 2. Moreover, in the present embodiment, each of the electrodes 3a and 3b also has a function to convert the surface acoustic wave into an electric signal, respectively. Moreover, each of the reflectors 4 and 5 has a function to reflect the surface acoustic wave that propagates in the substrate 2, and thereby confine between the reflector 4 and the reflector 5.

When a driving voltage is inputted to the IDT 3 (each of the electrodes 3a and 3b), a surface acoustic wave will be excited near the surface of the substrate 2, and an electric signal with a specific frequency due to the resonance will be outputted from the IDT 3 (each of the electrodes 3a and 3b). Each of the electrodes 3a and 3b has a plurality of electrode fingers 31 that are arranged in parallel at predetermined intervals, respectively, and makes a comb-teeth shape, as a whole.

Moreover, each of the reflectors 4 and 5 has a plurality of reflectors 41 and 51 arranged in parallel at predetermined intervals, respectively, and are making the shape of a rattan blind, as a whole. Accordingly, each of the reflectors 4 and 5 is formed, respectively, as to reflect the surface acoustic wave efficiently. The characteristics, such an oscillation frequency of the surface acoustic wave excited in the surface acoustic wave element 1, can be set to a desired one by adjusting the width, the space, the pitch, the thickness, and the like of these electrode fingers 31 and reflectors 41 and 51. Moreover, the structure of each of the reflectors 4 and 5 may be the same or different mutually, however, it is preferable to make approximately the same structure. Accordingly, a surface acoustic wave can be confined more securely between the reflector 4 and the reflector 5, and as a result, the surface acoustic wave can be resonated more largely.

It is preferable that the estrangement distance g between the IDT 3 and each of the reflectors 4 and 5 is a value of approximately 0.05 through 0.4 times of the wavelength λ of the surface acoustic wave excited in the substrate 2 or the value adding an integral multiple of the wavelength to this value, and more preferably the value of approximately 0.2 through 0.3 times or the value of adding an integral multiple of the wavelength to this value. Accordingly, offset between the phase of the surface acoustic wave in IDT 3 and the phase of the surface acoustic wave in each of the reflectors 4 and 5 can be made small, and as a result, the resonance of the surface acoustic wave by the reflectors 4 and 5 can be carried out more efficiently.

The insulating protection film 6 prevents foreign particles from adhering to the surface of the IDT 3 and the reflectors 4 and 5, and prevents the short-circuiting between the electrode fingers 31, via the foreign particles. In the present embodiment, the insulating protection film 6 is formed in the top face of the IDT 3 and the reflectors 4 and 5 corresponding to these patterns, as shown in FIG. 2, and the side faces of the IDT 3 and the reflectors 4 and 5 are exposed. Accordingly, the energy loss when a surface acoustic wave propagates in the substrate 2 can be suppressed to be small.

As for the composition material of this insulating protection film 6, it is preferable to use the one including at least one kind among silicone oxide, silicone nitride, and an aluminium oxide, as its main ingredient. While the insulating protection film 6 can be easily formed by forming the insulating protection film 6 of such material, the insulating protection film 6 can be made excellent in the insulation characteristic. Moreover, the temperature characteristic (frequency variation due to temperature change) can be also compensated (improved) by providing this insulating protection film 6 and suitably setting up this composition material, the thickness (film thickness), and the like.

The (average) thickness of such insulating protection film 6 is not specifically limited, however, preferably it is approximately 10 -through 1500 nm, and more preferably approximately 30 through 400 nm. By setting the thickness of the insulating protection film 6 within this range, decrease of the oscillation frequency of the surface acoustic wave due to the mass increase is prevented or suppressed while a sufficient insulating characteristic is exhibited. Moreover, the temperature characteristic (frequency temperature characteristic) can be made excellent (small).

Next, the angle ψ and the cut angle θ of the Euler angle (0, θ, ψ) in the quartz-rotator Y plate used for the substrate 2, and the relation of the cut angle θ and the normalized film-thickness H/λ (H denotes the average thickness of the interdigital transducer, and λ denotes the wavelength of the surface acoustic wave) of the IDT 3, and the composition material of IDT 3 will be described, respectively. The general definition of the Euler angle (φ, θ, ψ) is as follows. A device coordinate system (X, Y, Z) is rotated by φ around the Z-axis, then, the device is rotated by θ around a new Y' axis after the rotation of φ, and, finally is rotated by ψ around a new Z'' axis after the rotation of θ. Among these, the angle ψ is set to 90 ± 10°. That is, in the surface acoustic wave element 1, the IDT 3 is arranged so that the propagation direction (in the direction that is almost perpendicular to the longitudinal direction of the electrode finger 31) of the surface acoustic wave, which is excited near the surface of the quartz-rotator Y plate by this IDT 3, may become 90 ± 10° to the X-axis of the quartz-rotator Y plate.

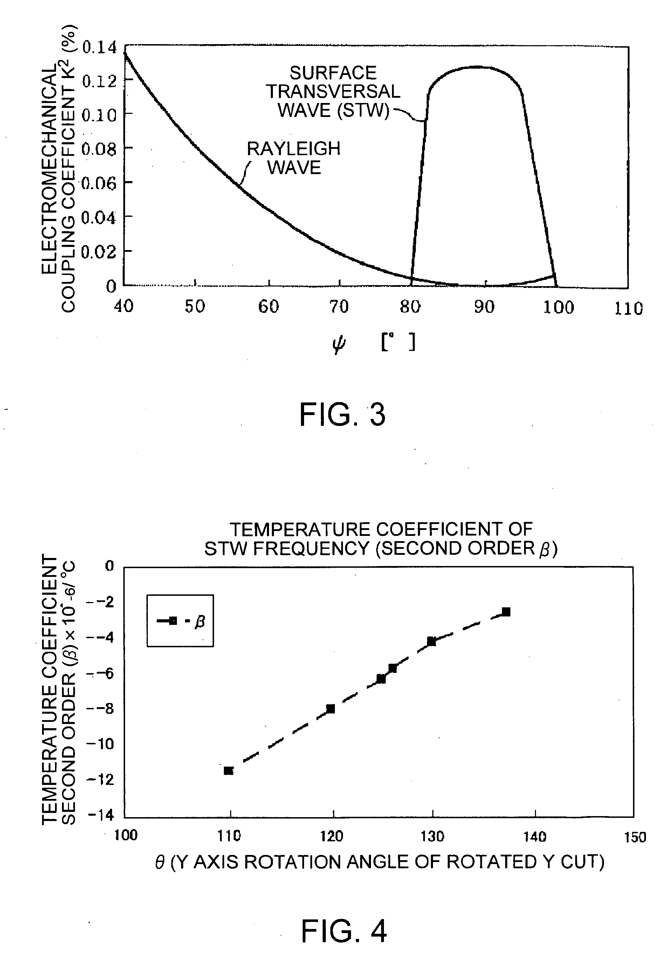

In FIG. 3, the relation between the angle ψ and the electromechanical coupling coefficient $k^2$ of various kinds of surface acoustic waves is shown. As shown in FIG. 3, the Rayleigh wave decreases as the angle ψ becomes larger, and becomes approximately zero at 90°. On the other hand, a surface transversal wave (STW) has a large peak in the range of 80 through 100° of the angle ψ. For this reason, by setting the angle ψ to 90 ± 10°, the surface acoustic wave having STW as its major component is excited by the IDT 3, efficiently. Because the acoustic velocity of STW is fast, the surface acoustic wave element 1 of higher frequency can be attained by using, as the surface acoustic wave, the one having STW as its major component.

Especially, it is preferable to set the angle ψ to 90 ± 2°. Accordingly, STW can be used efficiently as the surface acoustic wave. Moreover, as the surface acoustic wave, STW with especially a large electromechanical coupling co-efficient $k^2$ will be exited, and losses during the conversion of an electric signal and the surface acoustic wave is suppressed to be small. Moreover, since STW has a large reflective coefficient at each of the reflectors 4 and 5, the number of the reflectors 41 and 51 is suppressed as to be small, and miniaturization of the surface acoustic wave element 1 can be attained. On the other hand, the cut angle θ is set to 129 through 144°.

In FIG. 4, the relation between the cut angle θ of the quartz-rotator Y plate and the second-order temperature coefficient is shown. Here, the second-order temperature coefficient is a characteristic value indicating the second-order variation amount of the frequency to temperature change, and is a temperature characteristic appearing when the film thickness of the interdigital transducer film is set to an optimal value and the first-order temperature coefficient becomes around zero. It means that more excellent temperature characteristic is obtained, as this value becomes close to zero. As shown in FIG. 4, it is understood that the second-order temperature coefficient changes depending on the cut angle θ of the quartz-rotator Y plate, and is becoming smaller as the cut angle θ increases from 127° to 137°. Therefore, an excellent temperature characteristic can be obtained if a larger θ is used, however, because the film thickness of Al actually increases according to the Relation A, there are limitations in simply increasing the cut angle, such as the thickness variation and the increase of the Al film formation time at the time of Al etching or the film formation. Therefore, by setting the cut angle θ of the quartz-rotator Y plate to a range of 129 through 144°, the second-order temperature coefficient can be brought close to zero. As a result, the surface acoustic wave element 1 will have an excellent temperature characteristic. It is preferable to set the cut angle θ especially to 133 through 139°. Accordingly, the above described effect is exhibited more remarkably.

Furthermore, the cut angle θ with respect to the normalized film-thickness H/λ of the IDT 3 is set up as to satisfy the following Relation A.

(Relation A)

$$\theta min \ \square \ \theta \ \square \ \theta max$$

$$\theta min = 857.06(H/\lambda)^2 + 23.656(H/\lambda) + 123.68$$

$$\theta max = 2502.4(H/\lambda)^2 + 73.1(H/\lambda) + 121.7$$

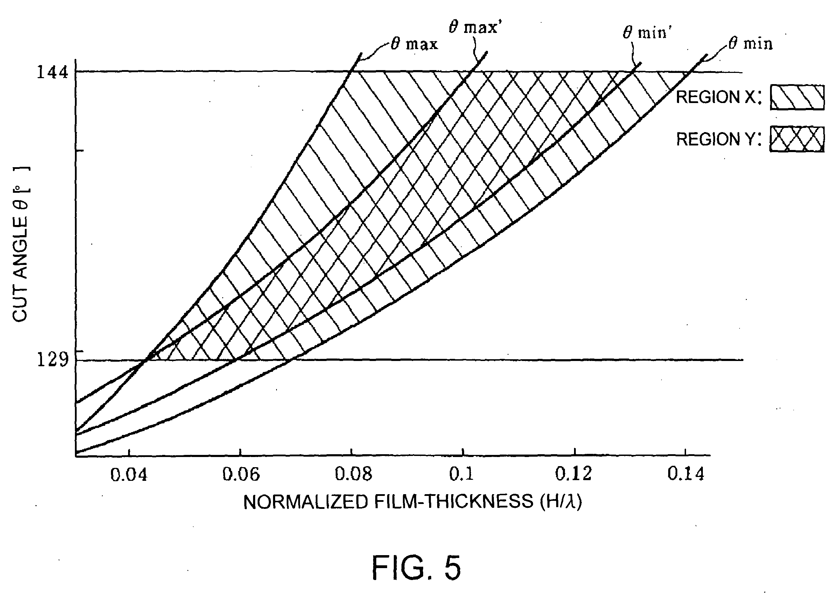

In FIG. 5, the relation between the normalized film-thickness H/λ of the IDT and the cut angle θ of the quartz-rotator Y plate is shown. The range which satisfies the Relation A is a range shown as Region X in FIG. 5. The inventor found out, as a result of the dedicated and repeated investigations, that the surface acoustic wave element 1 becomes excellent especially in the temperature characteristic by setting the cut angle θ and the normalized film-thickness H/λ of the IDT 3 to the values that satisfy a relation within the region X.

Especially, it is preferable to set the cut angle θ as to satisfy the following Relation A', namely, to set in the range shown as Region Y of FIG. 5 in order to obtain a peak temperature in the vicinity of the room temperature, and thereby the surface acoustic wave element 1 will have a more excellent temperature characteristic.

(Relation A')

$$\theta min' \ \square \ \theta \ \square \ \theta max'$$

$$\theta min' = 857.06 (H/\lambda)^2 + 40.797 (H/\lambda) + 124.4$$

$$\theta max' = 1193.6 (H/\lambda)^2 + 65.587 (H/\lambda) + 124.4$$

The IDT 3 is formed of Al as its main ingredient. Because the electrical resistance of Al is small, energy loss becomes smaller by forming the IDT 3 of Al as its main ingredient. For this reason, in the surface acoustic wave element 1, the resonance of the surface acoustic wave becomes sharper. Moreover, because the specific gravity of Al is small, the acoustic velocity change depending on the film thickness of the IDT 3 is suppressed to be small as compared with the cases using metal with a large specific gravity, such as tantalum, tungsten, and gold. Accordingly, variation of the center frequency can be suppressed. Furthermore, because the film thickness control of the IDT 3 becomes easy by forming the IDT 3 of Al as its main ingredient, the surface acoustic wave element 1 having high accuracy can be obtained.

This IDT 3 may be formed of Al alone, or a metallic element, such as Cu, Si, Ti, Mo, and Sc, may be added. By adding these metallic elements, migration tolerance of the IDT 3 can be improved. Moreover, the IDT 3 may be formed as a multilayer composition in which an electrode layer to be a barrier metal is provided at least in one face side, the top face or the bottom face side of the electrode layer formed of Al as its main ingredient.

The normalized film-thickness $H/\lambda$ of such IDT 3 differs depending on the cut angle $\theta$ of the quartz-rotator Y plate, however, preferably it is approximately 0.03 through 0.14, and more preferably approximately 0.055 through 0.125. By setting the normalized film-thickness $H/\lambda$ of the IDT 3 to this range, the temperature characteristic is further improved, and the electromechanical coupling coefficient $k^2$ becomes large, the energy loss during the electromechanical conversion can be suppressed to be small. Moreover, by setting the normalized film-thickness $H/\lambda$ of IDT 3 to this range, the mass loading effect of the IDT 3 is exhibited suitably, and it is possible to confine STW near the surface of the quartz-rotator Y plate. As a result, in the surface acoustic wave element 1, STW will be excited favourably.

In addition, as for each of the reflectors 4 and 5, it is preferable to make the same structure as that of the IDT 3, respectively. That is, it is preferable that each of the reflectors 4 and 5 is formed, respectively, of the same composition material as that of the IDT 3, and that the normalized film-thickness and the cut angle $\theta$ thereof satisfy the conditions A. Thereby, various kinds of characteristics of the surface acoustic wave element 1 can be further improved. Moreover, this enables each of the reflectors 4 and 5 to be formed simultaneously with the IDT 3, therefore, simplification of the manufacturing process of the surface acoustic wave element 1 can be also attained.

Moreover, it is preferable that the normalized film-thickness $H/\lambda$ of each of the reflectors 4 and 5 is approximately 0.03 through 0.14, respectively, and more preferably 0.055 through 0.125, like the IDT 3. Reflectivity of the surface acoustic wave can be made sufficiently large by setting the normalized film-thickness $H/\lambda$ of each of the reflectors 4 and 5 to this range. For this reason, the number of the reflectors 41 and 51 can be made less and miniaturization of the surface acoustic wave element 1 can be attained. In addition, the normalized film-thickness of each of the reflectors 4 and 5 may be set differently from the IDT 3, as required. In the above described surface acoustic wave element 1, various kinds of characteristics (especially temperature characteristic) becomes favourable by a synergy effect that the quartz-rotator Y plate is used as the substrate 2, and that the angle $\psi$ and the cut angle $\theta$ of the Euler angle $(0, \theta, \psi)$, the relation of the cut angle $\theta$ and the normalized film-thickness $H/\lambda$ of the IDT 3, and the composition material of IDT 3, are set (provided), respectively.

<Second embodiment>

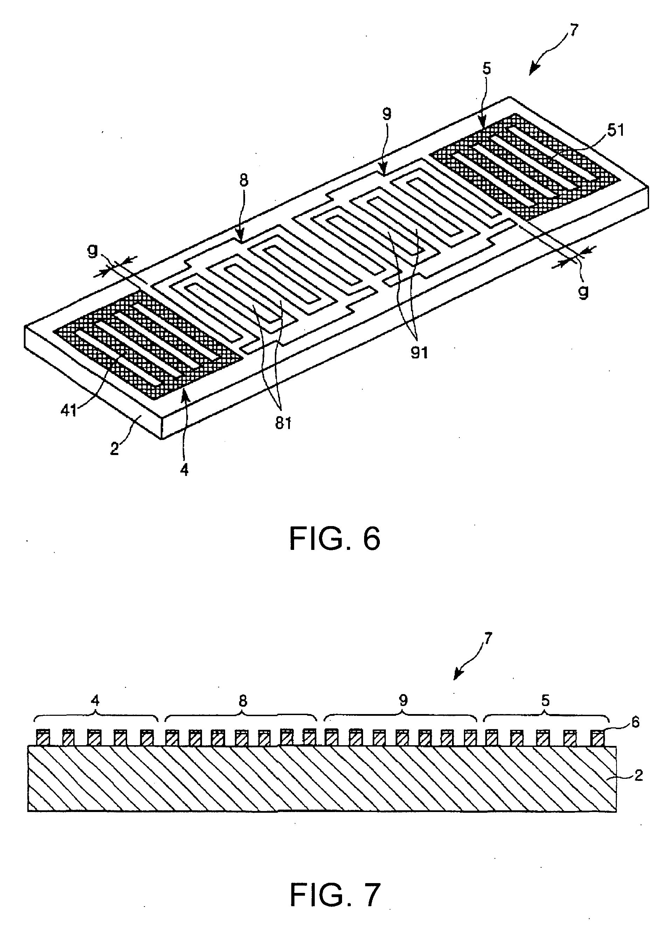

Next, a second embodiment of the surface acoustic wave element according to the present invention will be described. FIG. 6 is a perspective view showing the second embodiment of the surface acoustic wave element of the present invention, and FIG. 7 is a cross sectional view of the surface acoustic wave element shown in FIG. 6. In addition, in the following description, an upper side in FIG. 7 is called a "top", and a lower side is called a "bottom".

Hereinafter, the surface acoustic wave element of the second embodiment will be described focusing on differences from the surface acoustic wave element 1 of the first embodiment, and the description regarding the same matters will be omitted. A surface acoustic wave element 7 of the second embodiment is the same as the surface acoustic wave element 1 of the first embodiment except that IDT 8 used for an input and IDT 9 used for an output are provided, respectively, instead of IDT 3 having the combined functions to excite a surface acoustic wave and to convert the surface acoustic wave into an electric signal.

The IDT (input side electrode) 8 has a function to apply a voltage to the substrate 2 and excite a surface acoustic wave near the surface of the substrate 2. On the other hand, the IDT (output side electrode) 9 has a function to detect the surface acoustic wave which propagates near the surface of the substrate 2, and to convert the surface acoustic wave into an electric signal, and output to the outside. Accordingly, when a driving voltage is inputted to the IDT 8, a surface acoustic wave is excited in the substrate 2, and an electric signal with a specific frequency due to the resonance will be outputted from the IDT 9.

Each of the IDT 8 and 9 makes a comb-teeth shape having a plurality of electrode fingers 81 and 91 arranged at predetermined intervals, respectively, and the characteristics, such as an oscillation frequency of the surface acoustic wave, can be set to a desired one by adjusting the width, the space, the pitch, the thickness and the like of the electrode fingers 81 and 91 of each of the IDT 8 and 9. Also in the surface acoustic wave element 7 of this second embodiment, for example, an excellent performance as a narrow-band filter is obtained, while energy loss is suppressed to be small by a synergy effect that the quartz-rotator Y plate is used as the substrate 2, and that the angle $\psi$ and the cut angle $\theta$ of the Euler angle (0, $\theta$, $\psi$), a relation of the cut angle $\theta$ and the normalized film-thickness $H/\lambda$ of IDT 8 and 9, and the composition material of IDT 8 and 9 are set (provided), respectively. The above described surface acoustic wave elements 1 and 7 can be applied to various kinds of electronic equipment, and the electronic equipment obtained will have high reliability.

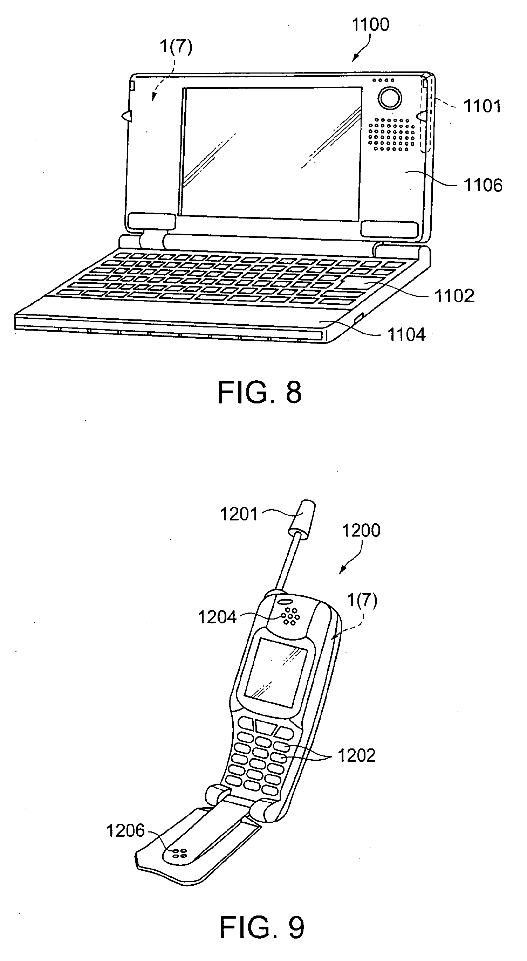

Next, electronic equipment including the surface acoustic wave element of the present invention will be described in detail based on the embodiments shown in FIG. 8 through FIG. 10. FIG. 8 is a perspective view showing the structure of a mobile type (or notebook type) personal computer to which the electronic equipment including the surface acoustic wave element of the present invention is applied. In this view, a personal computer 1100 is constituted by a main body portion 1104 equipped with a keyboard 1102 and a display unit 1106, and the display unit 1106 is supported rotatably to the main body portion 1104 via a hinge structure portion. In such personal computer 1100, the surface acoustic wave element 1 (or 7), which functions as a filter, a resonator, reference clocks, and the like, and an antenna 1101 are built in.

FIG. 9 is a perspective view showing the structure of a cellular phone (PHS is also included) to which the electronic equipment having the surface acoustic wave element of the present invention is applied. In this view, a cellular phone 1200 is equipped with an antenna 1201, a plurality of operation buttons 1202, a receiver 1204, and a speaker 1206, and between the operation button 1202 and the receiver 1204, a display portion is arranged. In such cellular phone 1200, the surface acoustic wave element 1 (or 7) which functions as a filter, a resonator, and the like are built in.

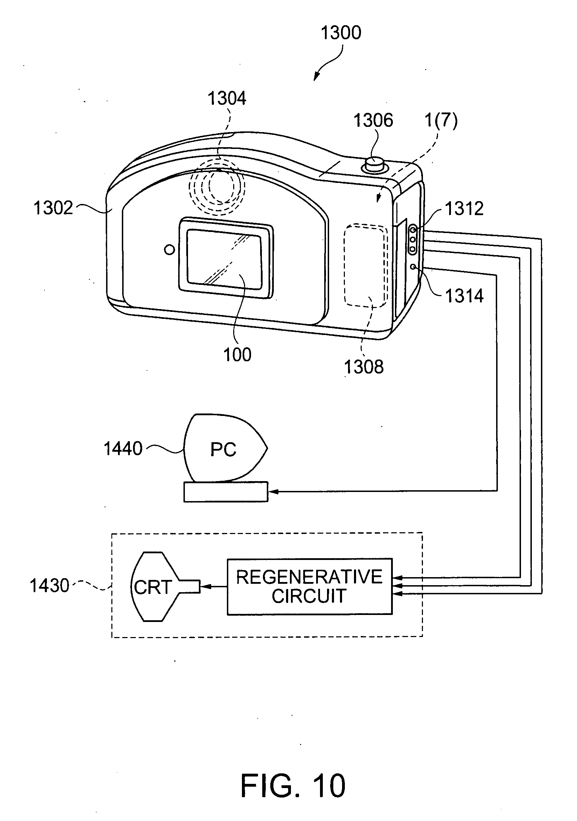

FIG. 10 is a perspective view showing the structure of a digital still camera to which the electronic equipment equipped with the surface acoustic wave element of the present invention is applied. In addition, in this view, the coupling to external apparatus is simply shown. Here, in an usual camera, a silver-salt photographic film is exposed based on the light image of a photographic subject, while in a digital still camera 1300, the light image of a photographic subject is photo-electric converted with imaging element, such as CCD (Charge Coupled Device), to generate an imaging signal (picture signal).

A display portion is provided on the back face of a case (body) 1302 in the digital still camera 1300 to form a structure in which displaying is carried out based on an imaging signal by the CCD, and the display portion functions as a finder to display a photographic subject as an electronic picture. Moreover, in the front face side (back face side in the view) of the case 1302, a light-receiving unit 1304 including an optical lens (imaging optical system), CCD, and the like are provided. If a photographer confirms an image of the photographic subject that is displayed on the display portion, and pushes a shutter button 1306, the CCD imaging signal at this time is transferred and stored to a memory 1308.

Moreover, in this digital still camera 1300, a video signal output terminal 1312 and an input/output terminal 1314 for data communications are provided at the side face of the case 1302. Then, as shown in the view, a television monitor 1430 is coupled to the video signal output terminal 1312, and a personal computer 1440 is coupled to the input/output terminal 1314 for data communications, respectively, as required. Furthermore, the structure is designed to output the imaging signal stored in the memory 1308 to the television monitor 1430 and to the personal computer 1440 by predetermined operations. In such digital still camera 1300, the surface acoustic wave element 1 (or 7) which functions as a filter, a resonator, and the like is built in.

In addition, electronic equipment that includes the surface acoustic wave element of the present invention can be applied to for example, an ink-jet type discharging device (for example, ink-jet printer), a laptop type personal computer, a television, a video camera, a video tape recorder, a car navigation device, a pager, an electronic notebook (the one with a communication function is also included), an electronic dictionary, a calculator, an electronic game machine, a word processor, a workstation, a videophone, a television monitor for crime prevention, an electronic binoculars, a POS terminal, a medical apparatus (for example, an electronic thermometer, a sphygmomanometer, a blood sugar meter, an electrocardiogram measurement device, an ultrasonic diagnosis equipment, an electronic endoscope), a fish detector, various kinds of measurement equipment, meters (for example, meters of vehicles, an airplane, and a ship), a flight simulator and the like, in addition to the portable computer (mobile type personal computer) of FIG. 8, the cellular phone of FIG. 9, and the digital still camera of FIG. 10.

As described above, although the surface acoustic wave element and the electronic equipment of the present invention have been described based on the illustrated embodiments, the present invention is not limited to these. For example, in the surface acoustic wave element of the present invention, the number of the reflector and the interdigital transducers may be changed according to the application, and the reflector also may be omitted. Moreover, in these embodiments, although the insulating protection film is provided in the top face of the interdigital transducers and the reflectors, the insulating protection film may be provided at least in the top face of the interdigital transducers. Moreover, the insulating protection film may be provided as to cover the whole surface of the quartz-rotator Y plate. Moreover, semiconductor elements that have various kinds of functions may be combined into the surface acoustic wave element of the present invention.

**[Embodiments]**

Next, specific embodiments of the present invention will be described.

**1. Manufacturing of surface acoustic wave element**

**(Embodiment 1)**

First of all, as the substrate, a quartz-rotator Y plate whose average thickness is 0.4 mm is prepared. The Euler angle of this quartz-rotator Y plate is (0, 133, 90). Aluminium is adhered on this quartz-rotator Y plate to form a conductive material layer by a vacuum deposition method or a sputtering method.

Next, silicon oxide ($SiO_2$) is adhered on this conductive material layer to form a silicon oxide layer (insulating material layer) whose average thickness is 40 nm by the CVD method or the sputtering method. Then, a resist layer with the shape corresponding to the IDT (interdigital transducer) and the reflectors is formed on the silicon oxide layer by a photo lithography method. Then, the unwanted conductive material layer and silicon oxide layer are removed by a dry etching method using this resist layer as a mask. Thereby, the IDT, the reflectors, and the insulating protection film are formed, and the surface acoustic wave element shown in FIG. 1 and FIG. 2 is obtained. In addition, the normalized film-thickness H/λ of the IDT and the reflector is 0.07. Moreover, the estrangement distance g between the IDT and each reflector is set to 0.25 times of the wavelength of the surface acoustic wave, respectively

**(Comparative examples 1 through 3)**

The surface acoustic wave element shown in FIG. 1 and FIG. 2 is obtained like the embodiment 1, except that, as the quartz-rotator Y plate, the one with the Euler angle as shown in Table 1 is used, and that the normalized film-thickness H/λ of the IDT and the reflector is changed as shown in Table 1.

[Table 1]

| | Euler angle | Normalized film-thickness of IDT and reflector | Frequency deviation (ppm) to reference frequency | | | | | | |
|---|---|---|---|---|---|---|---|---|---|
| | | | -40°C | -20°C | 0°C | 20°C | 40°C | 60°C | 80°C |
| Embodiment | 1 0,133,90 | 0.07 | -120 | -53 | -13 | 0 | -13 | -53 | -120 |
| Comparative example 1 | 0,126,90 | 0.02 | -170 | -75 | -19 | 0 | -19 | -75 | -170 |
| Comparative example 2 | 0,141,90 | 0.07 | -1800 | -1200 | -800 | 0 | 300 | 1000 | 1700 |
| Comparative example 3 | 0,126,90 | 0.07 | 3000 | 2000 | 1000 | 0 | -1200 | -2400 | -3900 |

**2. Evaluation**

With respect to the surface acoustic wave element of the embodiment 1 and the comparative examples 1 through 3, the frequency variation to temperature change is investigated, respectively. The result is shown in the table 1. The frequency deviation (ppm) to a reference frequency in each temperature (°C) is shown in Table 1.

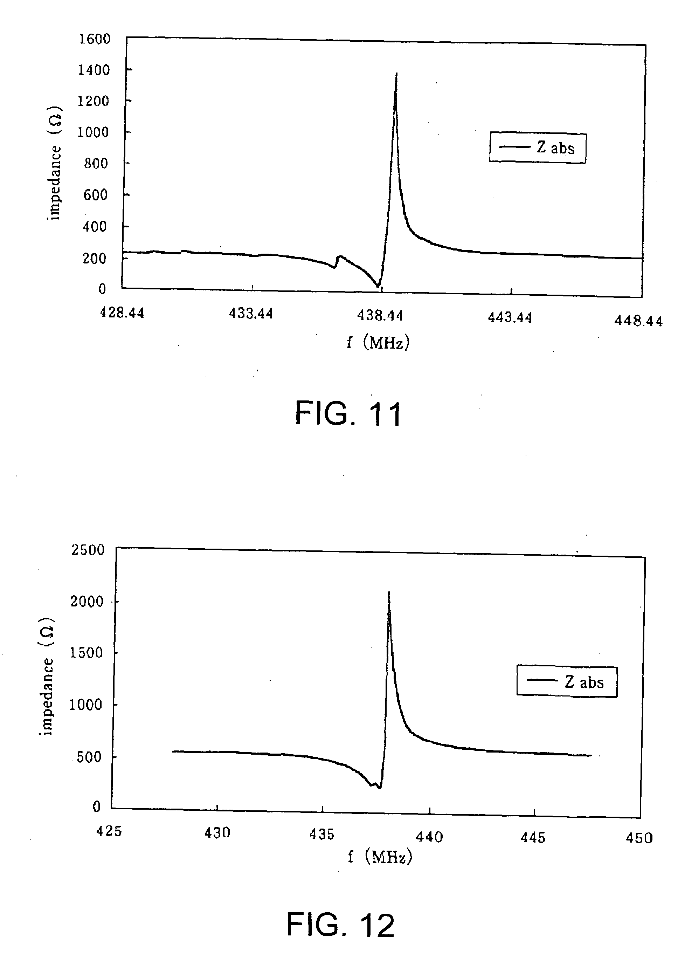

As apparent from Table 1, in the surface acoustic wave element (surface acoustic wave element of the present invention) of the embodiment 1, the frequency variation to temperature change is small. On the other hand, in each of the surface acoustic wave elements of the comparative examples 1 through 3, the frequency variation to temperature change is large. Moreover, in each of the surface acoustic wave elements of the embodiment 1, a sharp resonance is obtained as compared with the surface acoustic wave element of each of the comparative examples. Representatively, the impedance characteristic of the surface acoustic wave element of the embodiment 1 is shown in FIG. 11, and the impedance characteristic of the surface acoustic wave element in the comparative example 1 is shown in FIG. 12.

In addition, the surface acoustic wave elements shown in FIG. 6 and FIG. 7 are manufactured like the embodiment 1 and the comparative examples 1 through 3, and with respect to these, the frequency variation to temperature change is investigated, respectively, and as a result, almost the same result as the above is obtained. Moreover, the surface acoustic wave elements of the embodiments (the present invention) have small energy loss.

**EP 1 528 672 A2**

Reference numerals in the attached claims only serve clarification purposes and do not limit the scope of these claims.

**[List of Reference Numerals]**

| | |
|---|---|
| 1, 7: | Surface acoustic wave element |
| 2: | Substrate |
| 3: | IDT ( Interdigital Transducer ) |
| 3a, 3b: | Electrode (interdigital transducer) |
| 31: | Electrode finger |
| 4, 5: | Reflector |
| 41, | 51: Reflector |
| 6: | Insulating protection film |
| 8: | IDT (input side electrode) |
| 81: | Electrode finger |
| 9: | IDT (output side electrode) |
| 91: | Electrode finger |
| 1100: | Personal computer |
| 1101: | Antenna |
| 1102: | Keyboard |
| 1104: | Main body portion |
| 1106: | Display unit |
| 1200: | Cellular phone |
| 1201: | Antenna |
| 1202: | Operation button |
| 1204: | Receiver |
| 1206: | Speaker |
| 1300: | Digital still camera |
| 1302: | Case (body) |
| 1304: | Light-receiving unit |
| 1306: | Shutter button |
| 1308: | Memory |
| 1312: | Video signal output terminal |
| 1314: | Input/output terminal for data communications |
| 1430: | Television monitor |
| 1440: | Personal computer |

**Claims**

1. A surface acoustic wave element, comprising:

a quartz-rotator Y plate whose Euler angle is expressed with $(0, \theta, \psi)$; and a interdigital transducer that is provided on this quartz-rotator Y plate, and has a function to change an electric signal into a surface acoustic wave that propagates near a surface of the quartz-rotator Y plate, and/or a function to change the surface acoustic wave that propagates near the surface of the quartz-rotator Y plate into an electric signal,

wherein the interdigital transducer is formed of Al as a major ingredient and arranged so that an angle $\psi$, which a propagation direction of the surface acoustic wave and the X-axis of the quartz-rotator Y plate make, may become $90 \pm 10°$, and a normalized film-thickness $H/\lambda$ of the interdigital transducer (H denotes an average thickness of the comb-teeth electrode, and $\lambda$ denotes a wavelength of a surface acoustic wave) and a cut angle $\theta$ are set as to satisfy the following Relation A:

$$\theta min \square \theta \square \theta max \text{ (where, } \theta = 129 \text{ through } 144°)$$

10

$$\theta min = 857.06(H/\lambda)^2 + 23.656(H/\lambda) + 123.68$$

$$\theta max = 2502.4(H/\lambda)^2 + 73.1(H/\lambda) + 121.7$$

**2.** The surface acoustic wave element according to claim 1,
**characterized in that**
the normalized film-thickness H/λ is 0.03 through 0.14.

**3.** The surface acoustic wave element according to claim 1 or 2,
**characterized in that**
the surface acoustic wave is the one having a surface transversal wave as a major component.

**4.** The surface acoustic wave element according to any one of claim 1 through 3, *characterized in that*
the angle ψ is 90 ± 2°.

**5.** The surface acoustic wave element according to any one of claim 1 through 4, *characterized by* a pair of reflectors provided via the interdigital transducer, wherein each of the reflectors is formed of Al as a major ingredient and arranged so that the angle ψ, which a propagation direction of the surface acoustic wave and the X-axis of the quartz-rotator Y plate make, may become 90 ± 10°, and a normalized film-thickness of each of the reflectors and a cut angle θ are set as to satisfy the Relation A.

**6.** The surface acoustic wave element according to any one of claim 1 through 5, *characterized by* an insulating protection film provided at least in a top face of the comb-teeth electrode.

**7.** An electronic equipment, comprising:

the surface acoustic wave element according to any one of claims 1 through 6.

FIG. 1

FIG. 2

FIG. 3

FIG. 4

FIG. 5

FIG. 6

FIG. 7

**FIG. 8**

**FIG. 9**

1300

1304

1306  1(7)

1302

1312

1314

100

1308

1440  PC

1430  CRT  REGENERATIVE
CIRCUIT

# FIG. 10

FIG. 11

FIG. 12